# EUROPÄISCHE PATENTSCHRIFT

(11) **EP 2 647 271 B1**
(45) Veröffentlichungstag und Bekanntmachung des Hinweises auf die Patenterteilung: **29.06.2016**
(21) Anmeldenummer: 11794060.1
(22) Anmeldetag: 21.11.2011
(51) Int. Cl.: H05K 7/14, G11B 33/12, G06F 1/18

(54) **HALTESCHIENE FÜR EINE EINSCHUBBAUGRUPPE**
MOUNTING RAIL FOR AN INSERT ASSEMBLY
RAIL DE RETENUE POUR UN MODULE ENFICHABLE

(30) Priorität: 30.11.2010 DE 102010052928
(43) Veröffentlichungstag der Anmeldung: 09.10.2013
(73) Patentinhaber: Fujitsu Technology Solutions Intellectual Property GmbH, 80807 München (DE)
(72) Erfinder: SCHERER, August, 86424 Dinkelscherben (DE)
(74) Vertreter: Epping - Hermann - Fischer
(86) Internationale Anmeldenummer: PCT/EP2011/070590
(87) Internationale Veröffentlichungsnummer: WO 2012/072440

(56) Entgegenhaltungen:
- DE-B3-102007 024 896
- US-A- 6 067 225
- US-A1- 2009 279 249
- US-B1- 6 456 501

## Beschreibung

Die Erfindung betrifft eine Halteschiene für eine Einschubbaugruppe, die zum Festlegen in einem Einbaukäfig eines Computers vorgesehen ist, wobei die Halteschiene mindestens eine Auflagefläche zum Festlegen in einer Führungsschiene des Einbaukäfigs aufweist. Weiterhin betrifft die Erfindung eine Anordnung zum Festlegen einer Einschubbaugruppe in einem Einbaukäfig eines Computers, aufweisend eine Halteschiene mit wenigstens einer Auflagefläche zum Festlegen der Halteschiene in einer Führungsschiene des Einbaukäfigs und wenigstens eine an der Halteschiene angeordnete Befestigung für die Einschubbaugruppe, wodurch die Halteschiene seitlich an der Einschubbaugruppe festlegbar ist.

Halteschienen der oben genannten Art erlauben unter anderem einen besonders einfachen und schnellen Einbau und Ausbau von Einschubbaugruppen, insbesondere Laufwerken, in einem Computergehäuse. Die Laufwerke können problemlos in Stecker auf der Rückseite des Einbaukäfigs gesteckt werden, die in einem stabilen Blechteil eingeklipst sind. Das Herausziehen der Laufwerke aus dem Stecker ist dagegen problematisch mit den bekannten Laufwerksschienen, da die Steckkraft der Laufwerkanschlüsse in dem Stecker viel zu hoch ist.

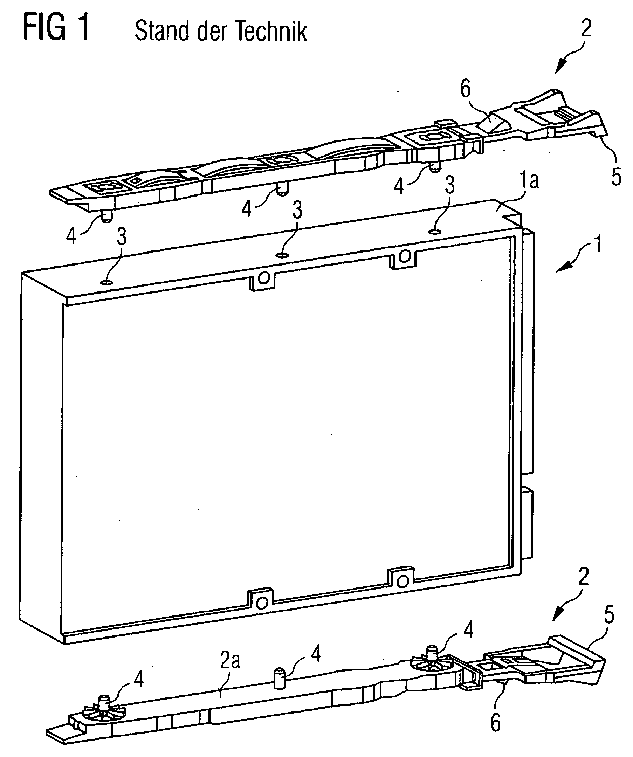

Bis jetzt sind Laufwerksschienen der oben genannten Art mit einem Griff ausgestattet, der im eingebauten Zustand aus dem Einbaukäfig des Computers herausragt. In der Regel wird eine Einschubbaugruppe mit zwei Schienen an gegenüberliegenden Seiten der Einschubbaugruppe seitlich befestigt (siehe Figur 1). Die Einschubbaugruppe samt zwei Halteschienen wird entlang den Führungsschienen des Einbaukäfigs in den Einbaukäfig hineingeschoben. Jede Halteschiene weist in der Regel an dem mit dem Griff ausgestatteten Ende eine Rastnase auf, die im eingebauten Zustand in eine Öffnung des Einbaukäfigs eingreift und somit die Halteschiene an dem Einbaukäfig festlegt. Um die Einschubbaugruppe mit den Halteschienen aus dem Einbaukäfig herauszuziehen, müssen zuerst die Griffe von beiden Halteschienen leicht in Richtung der Einschubbaugruppe abgebogen werden, um die Rastnase aus der Eingriffsöffnung zu lösen. Danach können die Halteschienen durch Ziehen an den jeweiligen Griffen herausgezogen werden.

Eine derartige Lösung ist z.B. in der US 6,456,501 offenbart.

Wie bereits oben erläutert, gelingt das reine Ziehen an den Griffen der Halteschienen, um die Halteschienen samt Einschubbaugruppe aus dem Einbaukäfig zu bekommen, nur schwer, wenn überhaupt, wenn die Einschubbaugruppe zusätzlich in einem Stecker eingesteckt ist.

Aus der US 2009/0279249 A1 ist ein Hebelmechanismus für Wechselfestplatten bekannt.

Aufgabe der vorliegenden Erfindung ist es, eine kostengünstige Halteschiene für eine Einschubbaugruppe sowie eine Anordnung zum Festlegen einer Einschubbaugruppe in einem Einbaukäfig eines Computers anzugeben, die das Entriegeln von Einschubbaugruppen, insbesondere eingesteckten Einschubbaugruppen, erleichtert.

Diese Aufgabe wird erfindungsgemäß dadurch gelöst, dass die Halteschiene an einem ersten Ende einen Hebel aufweist, der so auf einer Achse montiert ist, dass ein Exzenter entsteht und durch Betätigung des Hebels im eingebauten Zustand die Halteschiene in Richtung der Einschubbaugruppe gehoben wird. Der Exzenter hat die Funktion, die Verrastung der Halteschiene in dem Einbaukäfig vor dem Herausziehen zu lösen.

Vorzugsweise weist die Halteschiene eine Rastnase auf, die in eine entsprechende Öffnung des Einbaukäfigs (im Folgenden Eingriffsöffnung genannt) einrastet, wenn die Halteschiene im Einbaukäfig eingebaut ist. Durch Betätigung des Hebels wird die eingebaute Halteschiene automatisch durch den Exzenter nach oben gehoben und somit aus der Eingriffsöffnung des Einbaukäfigs herausgehoben.

Der Hebel ist vorzugsweise zusätzlich mit einer Nase ausgestattet, die gegen eine Kante des Einbaukäfigs drücken kann, um die entrastete Halteschiene aus dem Einbaukäfig zu hebeln. Falls die Einschubbaugruppe bereits eingesteckt ist, wird durch den Hebel genügend Kraft erzeugt, dass der Benutzer kontrolliert die Einschubbaugruppe aus dem Stecker ziehen kann. Anschließend kann er den Hebel als Griff verwenden, um die gelöste Einschubbaugruppe mit den Halteschienen ganz herauszuziehen.

Weitere Einzelheiten und Ausgestaltungen der Erfindung sind in den Unteransprüchen angegeben.

Die Erfindung wird nachfolgend in einem Ausführungsbeispiel anhand von Zeichnungen näher erläutert. Die Zeichnungen zeigen:
- Figur 1: eine Einschubbaugruppe und zwei Halteschienen zu ihrer Festlegung in einem Einbaukäfig nach dem Stand der Technik,
- Figur 2A bis C: eine perspektivische Ansicht beziehungsweise ein Ausschnitt einer Halteschiene nach der Erfindung,
- Figur 3: eine perspektivische Ansicht einer Anordnung nach der Erfindung mit eingebauter Einschubbaugruppe,
- Figur 4: einen Abschnitt der in Figur 3 dargestellten Anordnung im Querschnitt und
- Figur 5: eine perspektivische Ansicht einer Halteschiene mit dem Hebel in der nicht verrasteten Stellung.

Figur 1 zeigt eine Einschubbaugruppe 1 und zwei Halteschienen 2 zu ihrer Festlegung in einem hier nicht dargestellten Einbaukäfig. Die Einschubbaugruppe 1 weist in ihren Seitenflächen 1a jeweils drei Befestigungsöffnungen 3 auf. Die Halteschiene 2 weist an einer Seitenfläche 2a drei Haltestifte 4 auf, die zum Eingreifen in den drei Befestigungsöffnungen 3 vorgesehen sind. Weiterhin weist die Halteschiene 2 einen Griff 5 und eine Rastnase 6 an einem Ende auf. Der Griff 5 dient zum Herausziehen der Einschubbaugruppe 1 aus dem Einbaukäfig und die Rastnase 6 dient dazu, dass die Halteschiene 2 mit Einschubbaugruppe 1 in eingeschobenem Zustand in einer entsprechenden Eingriffsöffnung in dem Einbaukäfig einrastet.

Zum Einbringen der Einschubbaugruppe 1 in einem Einschubbaukäfig werden die zwei Halteschienen 2 so auf die Einschubbaugruppe gesteckt, dass die Seitenflächen 1a und 2a jeweils zueinander weisen und die Haltestifte 4 in die Befestigungsöffnungen 3 eingreifen. Zusammen mit den so festgelegten Halteschienen 2 wird die Einschubbaugruppe 1 in den Einbaukäfig eingeschoben.

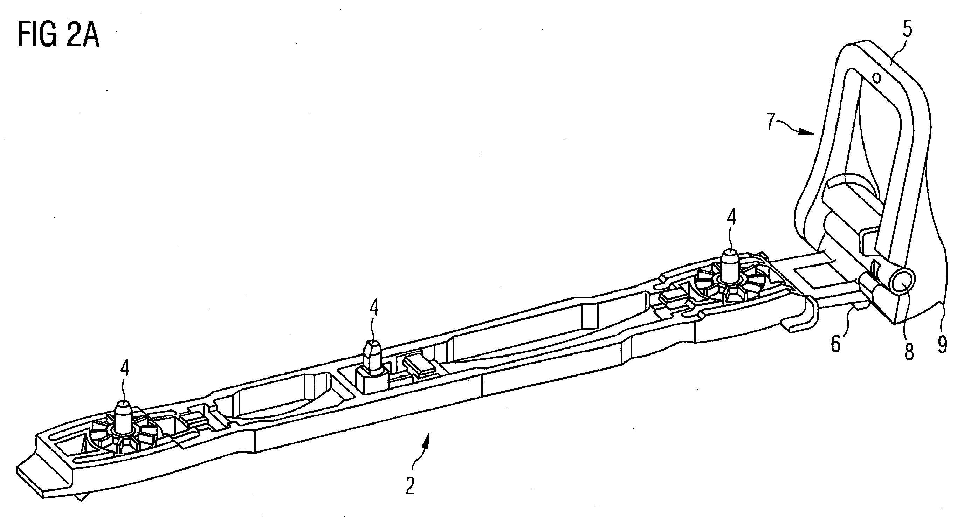

Figur 2A zeigt eine Halteschiene 2 nach der Erfindung. Ähnlich wie die in Figur 1 dargestellte Halteschiene 2 weist die Halteschiene 2 nach der Erfindung drei Haltestifte 4 und beispielsweise zwei Rastnasen 6 auf (nur eine Rastnase 6 ist in Figur 2A sichtbar). Die Rastnasen 6 sind an einem ersten Ende der Halteschiene 2 angeordnet. Anders als in Figur 1 weist die erfindungsgemäße Halteschiene 2 am ersten Ende einen Hebel 7 mit Griff 5 auf, der auf einer Achse 8 der Halteschiene 2 montiert ist. Der Griff 5 ist zum Drehen des Hebels 7 und zum Ziehen der Halteschiene 2 vorgesehen. Der Hebel 7 weist eine Hebelnase 9 auf.

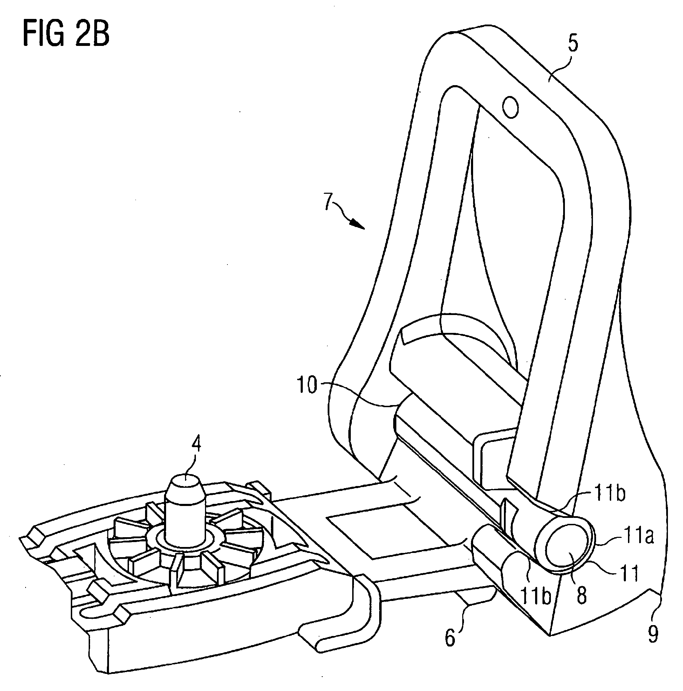

Figur 2B zeigt einen vergrößerten Abschnitt des ersten Endes der Halteschiene 2. Zur Montage weist der Hebel 7 eine Öffnung 10, die rund ausgebildet ist und zum Einstecken eines Endes der Achse 8 vorgesehen ist, und eine Ausnehmung 11 auf, die als ein runder Abschnitt 11a und ein anschließender schlitzartiger Abschnitt 11b ausgebildet ist.

Der Durchmesser des runden Abschnittes 11a ist ungefähr so groß wie der Durchmesser der Achse 8 damit nach der Montage des Hebels 7 die Achse 8 in dem runden Abschnitt 11a der Ausnehmung 11 festgehalten ist bzw. der runde Abschnitt 11a der Ausnehmung 11 teilweise die Achse 8 umgreift. Die Breite des schlitzartigen Abschnittes 11b ist geringfügig kleiner als der Durchmesser der Achse 8, sodass die Achse 8 in montierten Zustand nicht versehentlich aus dem runden Abschnitt 11a der Ausnehmung 11 rutschen kann. Der Hebel 7 ist bevorzugt aus einem Kunststoff hergestellt und weist eine gewisse Elastizität auf. Nach dem Einstecken eines Endes der Achse 8 in die runde Öffnung 10 des Hebels 7 wird das andere Ende der Achse 8 durch den schlitzartigen Abschnitt 11b der Ausnehmung 11 gedrückt, bis die Achse 8 in den runden Abschnitt 11a einrastet. Durch das Drücken der Achse 8 werden die zwei Seitenwände des schlitzartigen Abschnittes 11b vorübergehend auseinander gedehnt.

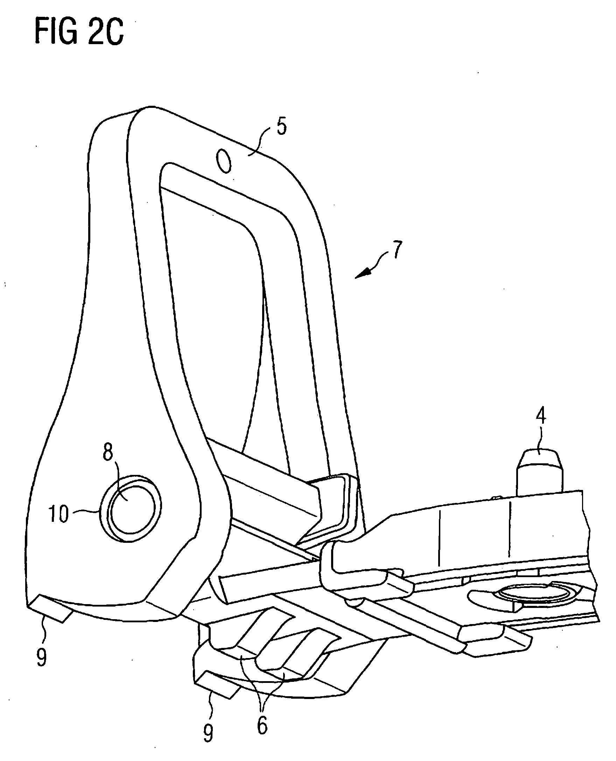

Figur 2C zeigt den gleichen Abschnitt wie Figur 2B von der Seite der runden Öffnung 10 des Hebels 7. Hier sind die zwei Rastnasen 6 sichtbar. Ausführungsformen der Halteschiene 2 mit einer Rastnase 6 sind auch Teil der Erfindung.

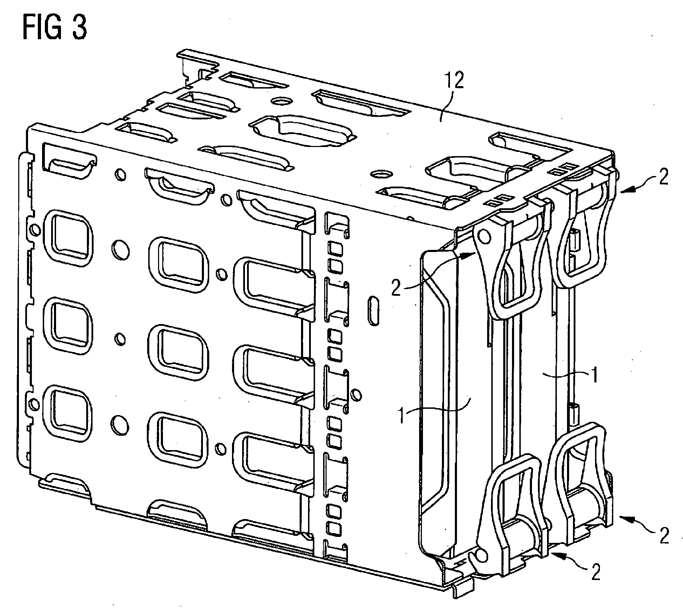

Figur 3 zeigt zwei Einschubbaugruppen 1, die jeweils mit zwei Halteschienen 2 nach der Erfindung ausgestattet sind und bereits in einem Einbaukäfig 12 eingeschoben und fixiert sind.

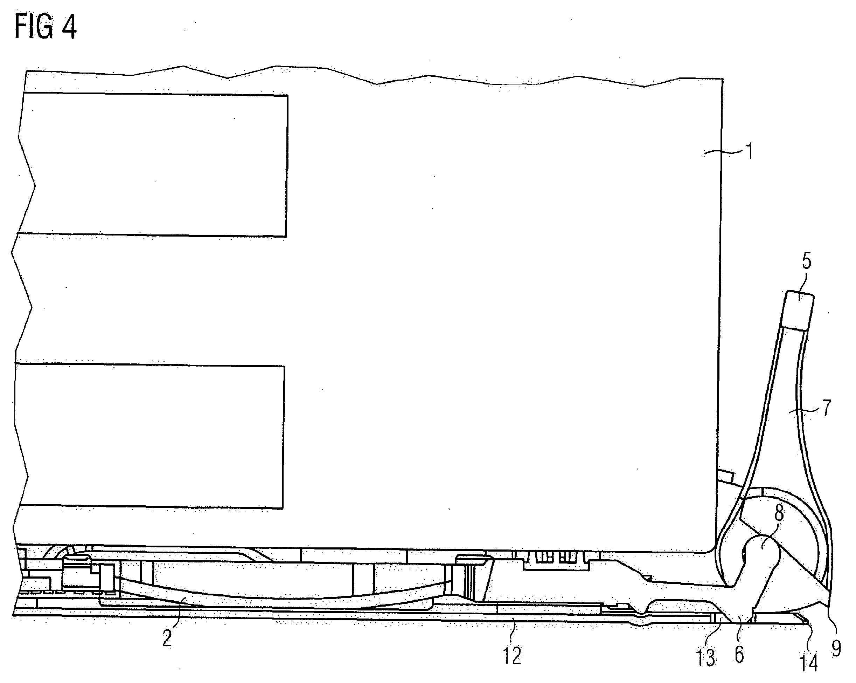

Figur 4 zeigt einen Querschnitt eines Abschnittes der in Figur 3 dargestellten Anordnung. Die Rastnase 6 der Halteschiene 2 ist bereits in einer Eingriffsöffnung 13 des Einbaukäfigs 12 eingerastet. Der Hebel 7 ist exzentrisch um die Achse 8 gelagert, sodass ein Exzenter entsteht. Durch den Exzenter wird die Rastnase 6 beim Drehen des Hebels 7 aus der Eingriffsöffnung 13 des Einbaukäfigs 12 gehoben. Die Rastnase 6 und die Achse 8 sind möglichst nah aneinander geordnet, um die Hebelwirkung des Exzenters beim Lösen der Rastnase 6 von der Eingriffsöffnung 13 besser auszunutzen. Durch anschließendes Ziehen der Halteschiene 2 wird die Einschubbaugruppe 1 komplett von dem Einbaukäfig 12 befreit.

Die Hebelnase 9 ist so angeordnet, dass sie beim Drehen des Hebels an einer Kante 14 des Einbaukäfigs 12 greift, nach dem die Rastnase 6 von der Eingriffsöffnung 13 befreit ist. Dadurch kann zusätzliche Kraft in der Ausziehrichtung gewonnen werden. Dies ist nötig, wenn die Einschubbaugruppe 1 im Einbaukäfig 12 in einem Stecker (nicht in Figur 4 sichtbar) eingesteckt ist, um die Steckkraft der Einschubbaugruppe 1 in dem Stecker zu überwinden.

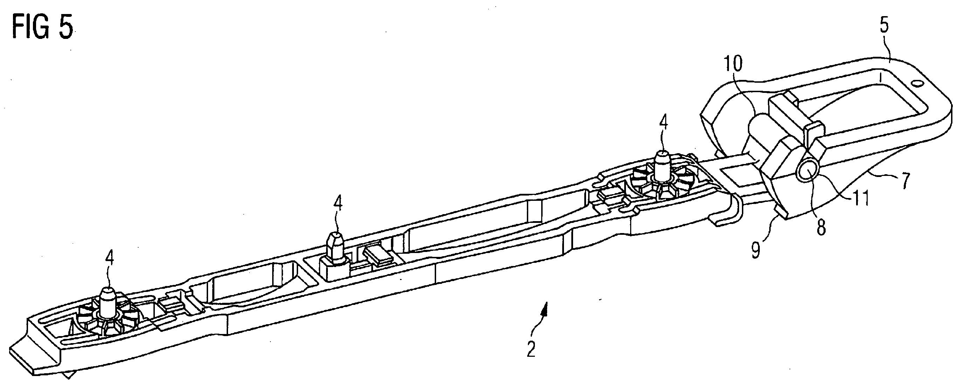

Figur 5 zeigt eine Halteschiene 2 nach der Erfindung, bei der der Hebel 7 in geöffnetem Zustand dargestellt ist.

### Bezugszeichenliste

- 1: Einschubbaugruppe
- 1a: Seitenfläche der Einschubbaugruppe
- 2: Halteschiene
- 2a: Seitenfläche der Halteschiene
- 3: Befestigungsöffnung der Einschubbaugruppe
- 4: Haltestift
- 5: Griff
- 6: Rastnase
- 7: Hebel
- 8: Achse
- 9: Hebelnase
- 10: Öffnung des Hebels
- 11: Ausnehmung des Hebels
- 12: Einbaukäfig
- 13: Eingriffsöffnung
- 14: Kante des Einbaukäfigs

## Patentansprüche

1. Halteschiene (2) für eine Einschubbaugruppe (1), die zum Festlegen in einem Einbaukäfig (12) eines Computers vorgesehen ist, wobei die Halteschiene (2) mindestens
- eine Auflagefläche zum Festlegen in einer Führungsschiene des Einbaukäfigs (12) aufweist und
- eine Befestigung für die Einschubbaugruppe (1), wodurch die Halteschiene (2) seitlich an der Einschubbaugruppe (1) festlegbar ist, und wobei
die Halteschiene (2) an einem ersten Ende einen Hebel (7) aufweist, **dadurch gekennzeichnet, dass** der Hebel (7) so auf einer Achse (8) gelagert ist, dass ein Exzenter entsteht und durch Betätigung des Hebels (7) im eingebauten Zustand die Halteschiene (2) in Richtung der Einschubbaugruppe (1) gehoben wird.

2. Halteschiene (2) nach Anspruch 1,
**dadurch gekennzeichnet, dass**
der Hebel (7) so gelagert ist, dass durch Betätigen des Hebels (7) im eingebauten Zustand die Halteschiene (2) aus dem Einbaukäfig (12) bewegt wird.

3. Halteschiene (2) nach Anspruch 1 oder 2,
**dadurch gekennzeichnet, dass**
der Hebel (7) mindestens eine Hebelnase (9) aufweist, die gegen eine Kante (14) des Einbaukäfigs (12) drücken kann, um die Halteschiene (2) aus dem Einbaukäfig (12) zu drücken.

4. Halteschiene (2) nach einem der vorherigen Ansprüche, **dadurch gekennzeichnet, dass**
die Halteschiene (2) am ersten Ende eine Rastnase (6) aufweist, die im eingebauten Zustand in eine Öffnung des Einbaukäfigs (12) eingreift, um die Halteschiene (2) in Einschubrichtung an dem Einbaukäfig (12) festzulegen.

5. Anordnung zum Festlegen einer Einschubbaugruppe (1) in einem Einbaukäfig (12) eines Computers, aufweisend
- einen Einbaukäfig (12),
- eine Halteschiene (2) mit wenigstens einer Auflagefläche zum Festlegen der Halteschiene (2) in einer Führungsschiene des Einbaukäfigs (12) und
- wenigstens eine an der Halteschiene (2) angeordnete Befestigung für die Einschubbaugruppe (1), wodurch die Halteschiene (2) seitlich an der Einschubbaugruppe (1) festlegbar ist,
**dadurch gekennzeichnet, dass**
die Halteschiene (2) nach einem der Ansprüche 1 bis 4 ausgebildet ist.

6. Anordnung zum Festlegen einer Einschubbaugruppe (1) in einem Einbaukäfig (12) eines Computers, aufweisend
- einen Einbaukäfig (12),
- eine Halteschiene (2) mit wenigstens einer Auflagefläche zum Festlegen der Halteschiene (2) in einer Führungsschiene des Einbaukäfigs (12) und
- wenigstens eine an der Halteschiene (2) angeordnete Befestigung für die Einschubbaugruppe (1), wodurch die Halteschiene (2) seitlich an der Einschubbaugruppe (1) festlegbar ist,
**dadurch gekennzeichnet, dass**
die Halteschiene (2) nach Anspruch 3 ausgebildet ist und der Einbaukäfig (12) auf die mit der Führungsschiene ausgestatteten Flächen eine entsprechend lange Kante (14) nach Außen aufweist, auf der die Hebelnase (9) abdrücken kann, um die Halteschiene (2) von dem Einbaukäfig (12) heraus zu bewegen.

## Claims

1. Mounting rail (2) for an insert assembly (1) provided for fixing in an installation cage (12) of a computer, wherein the mounting rail (2) comprises at least
- one bearing surface for fixing in a guide rail of the installation cage (12) and
- one fastening for the insert assembly (1), whereby the mounting rail (2) can be fixed laterally on the insert assembly (1), and wherein
the mounting rail (2) comprises a lever (7) at a first end, **characterized in that** the lever (7) is mounted on a shaft (8) such that an eccentric is formed and, by actuating the lever (7) in the installed state, the mounting rail (2) is lifted in the direction of the insert assembly (1).

2. Mounting rail (2) according to Claim 1,
**characterized in that**
the lever (7) is mounted such that, by actuating the lever (7) in the installed state, the mounting rail (2) is moved from the installation cage (12).

3. Mounting rail (2) according to Claim 1 or 2,
**characterized in that**
the lever (7) comprises at least one lever lug (9), which can press against an edge (14) of the installation cage (12) in order to press the mounting rail (2) from the installation cage (12).

4. Mounting rail (2) according to one of the preceding claims,
**characterized in that**
the mounting rail (2) at the first end comprises a detent lug (6), which in the installed state engages into an opening in the installation cage (12) in order to fix the mounting rail (2) to the installation cage (12) in the direction of insertion.

5. Arrangement for fixing an insert assembly (1) in an installation cage (12) of a computer, comprising
- an installation cage (12),
- a mounting rail (2) having at least one bearing surface for fixing the mounting rail (2) in a guide rail of the installation cage (12), and
- at least one fastening, arranged on the mounting rail (2), for the insert assembly (1), whereby the mounting rail (2) can be fixed laterally to the insert assembly (1),
**characterized in that**
the mounting rail (2) is formed according to one of Claims 1 to 4.

6. Arrangement for fixing an insert assembly (1) in an installation cage (12) of a computer, comprising
- an installation cage (12),
- a mounting rail (2) having at least one bearing surface for fixing the mounting rail (2) in a guide rail of the installation cage (12), and
- at least one fastening, arranged on the mounting rail (2), for the insert assembly (1), whereby the mounting rail (2) can be fixed laterally to the insert assembly (1),
**characterized in that**
the mounting rail (2) is formed according to Claim 3 and the installation cage (12), on the surfaces equipped with the guide rail, comprises a correspondingly long edge (14) outwardly, against which the lever lug (9) can press in order to move the mounting rail (2) out from the installation cage (12).

## Revendications

1. Rail de soutien (2) pour un sous-ensemble enfichable (1), lequel est conçu pour le calage dans un panier de montage (12) d'un ordinateur, le rail de soutien (2) comprenant
- au moins une surface d'appui destinée au calage dans un rail de guidage du panier de montage (12) et
- une fixation pour le sous-ensemble enfichable (1), par laquelle le rail de soutien (2) peut être calé latéralement sur le sous-ensemble enfichable (1), et
- le rail de soutien (2) possédant un levier (7) à une première extrémité,
**caractérisé en ce que** le levier (7) est supporté sur un axe (8) de telle sorte qu'il se produit un excentrique et l'actionnement du levier (7) à l'état monté provoque un levage du rail de soutien (2) en direction du sous-ensemble enfichable (1).

2. Rail de soutien (2) selon la revendication 1, **caractérisé en ce que** le levier (7) est supporté de telle sorte que l'actionnement du levier (7) à l'état monté déplace le rail de soutien (2) hors du panier de montage (12).

3. Rail de soutien (2) selon la revendication 1 ou 2, **caractérisé en ce que** le levier (7) possède au moins un tenon de levier (9) qui peut exercer une pression contre un bord (14) du panier de montage (12) afin de pousser le rail de soutien (2) hors du panier de montage (12).

4. Rail de soutien (2) selon l'une des revendications précédentes, **caractérisé en ce que** le rail de soutien (2) possède à la première extrémité un tenon d'encliquetage (6) qui, à l'état monté, vient en prise dans une ouverture du panier de montage (12) afin de caler le rail de soutien (2) dans le sens de l'enfichage sur le panier de montage (12).

5. Arrangement de calage d'un sous-ensemble enfichable (1) dans un panier de montage (12) d'un ordinateur, comprenant
- un panier de montage (12),
- un rail de soutien (2) doté d'au moins une surface d'appui destinée au calage du rail de soutien (2) dans un rail de guidage du panier de montage (12) et
- au moins une fixation disposée sur le rail de soutien (2) pour le sous-ensemble enfichable (1), par laquelle le rail de soutien (2) peut être calé latéralement sur le sous-ensemble enfichable (1),
**caractérisé en ce que** le rail de soutien (2) est configuré selon l'une des revendications 1 à 4.

6. Arrangement de calage d'un sous-ensemble enfichable (1) dans un panier de montage (12) d'un ordinateur, comprenant
- un panier de montage (12),
- un rail de soutien (2) doté d'au moins une surface d'appui destinée au calage du rail de soutien (2) dans un rail de guidage du panier de montage (12) et
- au moins une fixation disposée sur le rail de soutien (2) pour le sous-ensemble enfichable (1), par laquelle le rail de soutien (2) peut être calé latéralement sur le sous-ensemble enfichable (1).
**caractérisé en ce que** le rail de soutien (2) est configuré selon la revendication 3 et le panier de montage (12) possède, sur les surfaces équipées du rail de guidage, une arête (14) de longueur correspondante vers l'extérieur, sur laquelle le tenon de levier (9) peut exercer une pression afin de déplacer le rail de soutien (2) hors du panier de montage (12).
